# EUROPEAN PATENT SPECIFICATION

(11) **EP 0 345 343 B1**
(45) Date of publication and mention of the grant of the patent: **25.08.1993**
(21) Application number: 89901495.5
(22) Date of filing: 28.10.1988
(51) Int. Cl.: H01L 31/08, H01L 27/14, G01J 5/20

(54) **METHOD AND APPARATUS FOR DETECTING INFRARED RADIATION**
VERFAHREN UND VORRICHTUNG ZUR DETEKTION VON INFRAROTSTRAHLUNG
PROCEDE ET APPAREIL DE DETECTION D'UN RAYONNEMENT INFRA-ROUGE

(30) Priority: 23.11.1987 US 123842
(43) Date of publication of application: 13.12.1989
(73) Proprietor: Santa Barbara Research Center, Goleta California 93117 (US)
(72) Inventor: AHLGREN, William, L., Goleta, CA 93117 (US); SCHULTE, Eric F., Santa Barbara, CA 93105 (US)
(74) Representative: KUHNEN, WACKER & PARTNER
(86) International application number: US8803792
(87) International publication number: WO8905043

(56) References cited:
- EP-A- 0 137 988
- EP-A- 0 260 955
- US-A- 3 760 240
- US-A- 4 053 919
- US-A- 4 313 127
- US-A- 4 521 798
- US-A- 4 549 195
- US-A- 4 553 152
- US-A- 4 559 695
- US-A- 4 614 960
- IEEE TRANSACTIONS ON ELECTRON DEVICES, Vol. ED-25, No. 2, February 1978, N. Bluzer et al: "Buffered Direct Injection of Photocurrents into Charge-Coupled Devices", see page 160 - page 166.

## Description

### BACKGROUND OF THE INVENTION

### 1. Field of the Invention

This invention relates to the field of infrared sensing, and more particularly concerns a method and apparatus for detecting infrared radiation.

### 2. Description of Related Art

Elemental infrared detectors are often used in surveillance, target seeking, and search and tracking imaging systems to sense the presence of electromagnetic radiation having wavelengths from 1-30 µm. To detect infrared radiation, these elemental detectors often use temperature sensitive pyroelectric and ferroelectric materials such as triglicine sulfate and lanthanum doped lead zirconate titanate crystals. Such crystals exhibit spontaneous electrical polarization in response to incident infrared radiation which creates a potential drop across electrodes attached to the crystals. Photoconductive materials such as lead-sulfide and mercury-cadmium-telluride may also be used in which the resistance of the material changes as a function of incident radiation. Finally, photovoltaic devices such as those fabricated from mercury-cadmium-telluride, indium antimonide, or similar materials may be used in which intrinsic band-to-band electron-hole excitation generates a current or voltage which is proportional to the incident radiation flux.

Arrays of such elemental detectors may be used to form thermal imaging systems. In real-time thermal imaging systems such as forward looking infrared ("FLIR") imaging sensors, oscillating prism mirrors are used to scan radiation emitted by a source across a one-dimensional array of elemental detectors. When the elemental detectors are used in this manner, the temporal outputs of the detectors may be used to generate a two-dimensional representation of the image. In two-dimensional detector array imaging systems which can utilize either staring or scanning arrays, the elemental detectors produce free charge carriers or currents which may then be monitored by an appropriate readout integrated circuit such as a charge-coupled device ("CCD"). The output from the CCD can be processed by various techniques such as time delay and integration or parallel-to-serial scan conversion, with the choice depending on the system requirements of frame rate, signal-to-noise ratios, etc. Other readout devices may also be used.

While the detector structures described above are effective, they generally have several drawbacks in terms of fabrication. First, many of such detector structures are hybridized in which the detector and the readout device are separately fabricated and then mechanically bonded. Because the formation of hybridized structures involves additional processing steps, such structures tend to have lower yield during production when compared to monolithic devices (i.e., devices in which the detector and the readout and signal processing circuit are fabricated in one material system). In addition, there is a greater likelihood that defects will be unintentionally introduced during fabrication resulting in lower reliability and reduced performance. Monolithic detectors, while avoiding the additional processing steps required for hybridization, suffer from the necessity of using the same material as the infrared detector for the signal processing circuits. This material (e.g., HgCdTe or InSb) invariably leads to lower performance signal processing circuits than circuits formed from silicon or gallium arsenide, for which the fabrication technology is well-developed.

From US-A-4 553 152 a monolithic infrared detector structure is known comprising a substrate form for gallium arsenide with the topmost region of said substrate being n-doped. On said substrate adjacent to each other first and second semiconductor layers forming the IR-detection part and readout and signal processing circuits are provided. The layers forming the IR-detector part are formed by molecular beam epitaxy thereby presenting crystalline continuity with the substrate and thus forming a monolithic structure with the substrate.

### SUMMARY OF THE INVENTION

The disadvantages shown by the description of the afore mentioned prior art are overcome by the present invention by a method in accordance with claim 8 and apparatuses in accordance with claims 1 and 15.

### BRIEF DESCRIPTION OF THE DRAWINGS

The various advantages of the present invention will become apparent to one skilled in the art upon reading the following specification and by reference to the following drawing in which:

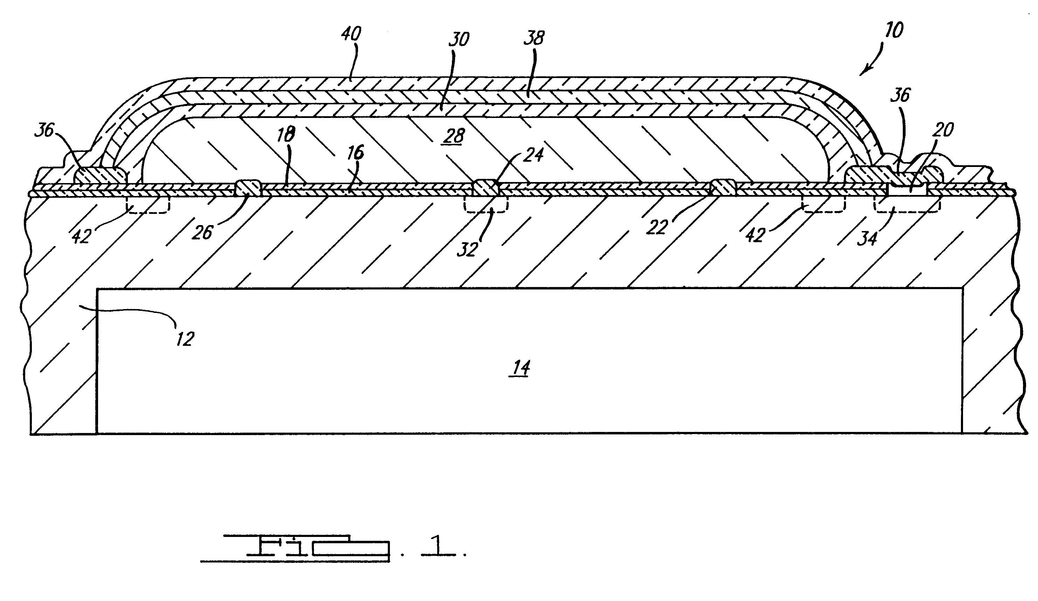

The FIGURE is a cross-sectional view of the preferred embodiment of the apparatus for detecting infrared radiation according to the present invention.

### DESCRIPTION OF THE PREFERRED EMBODIMENT

According to the preferred embodiment of the present invention, a structure 10 for detecting infrared radiation is provided as shown 4 in the FIGURE. The structure 10 may be used as a single detection element, or be part of a multiple-element imaging device. The structure 10 comprises a substrate 12 which may be made of silicon, gallium arsenide, or germanium, though it is to be understood that other suitable materials may be used. The substrate 12 comprises suitable readout and signal processing circuits, generally designated by the numeral 14, for converting the output of the semiconductor layers described below into useable form. The readout and signal processing circuits 14 may be similar to that disclosed in Bluzer, N., and Stehlac, R., "Buffered Direct Injection of Photocurrents into Charge-Coupled Devices", IEEE Transactions on Electron Devices, ED 25, n.2 p. 160 February 1978, which is hereby incorporated by reference. It should be understood that other suitable means for processing the output from the semiconductor layers may be used.

To control the electrical properties of the surface of the substrate, a first passivation layer 16 is provided. The first passivation layer 16 is selected from materials which provide optimum passivation for the substrate 12. Such materials may include SiO₂ or Si₃N₄, though it is to be understood that other suitable materials may be used. A second passivation layer 18 is deposited on the first passivation layer 16. The second passivation layer 18 is formed of one of several materials which provide optimum passivation for the infrared-active semiconductor layers described below and forms a surface on which nucleation of the infrared-active semiconductor layers does not occur. Such materials may include SiO₂ or ZnS, though it is to be understood that other suitable materials may be used. The first and second passivation layers 16 and 18 have a ohmic contact 20 and a plurality of nucleation windows 22-26. The ohmic contact 20 is used for providing electrical communication between the second semiconductor layer described below and the readout and signal processing circuits 14. The nucleation windows 22-26 are used for providing seed locations for nucleation of the first semiconductor layer. In addition, the nucleation window 24 allows electrical communication between the first semiconductor layer and the readout and signal processing circuits 14.

To generate a photocurrent in response to incident radiation, the structure 10 further comprises a first semiconductor layer 28 and a second semiconductor layer 30. The first and second semiconductor layers 28 and 30 together comprise the base and collector layers of a heterojunction photodiode. The first semiconductor layer 28 comprises a layer of mercury-cadmium-telluride having a stoichiometric relationship defined by Hg₁₋ₓCdₓTe. The composition value of x is chosen so that the first semiconductor layer 28 is sensitive to infrared radiation of a particular wavelength in the infrared spectrum. For example, if the composition value of x is chosen to be approximately 0.2, the first semiconductor layer 28 will be sensitive to long wavelength infrared radiation having a cut-off wavelength of approximately 10-12 µm at the desired operating temperature (e.g., 77 Kelvin). It is to be understood, however, that the first semiconductor layer 28 may comprise other suitable materials such as mercury-zinc-telluride, mercury-cadmium-selenide, mercury-zinc-selenide, mercury-cadmium-sulfide, mercury-zinc-sulfide, lead-tin-telluride, lead-tin-selenide, lead-tin-sulfide, indium-arsenide-antimonide, gallium-indium-antimonide, or gallium-antimonide-arsenide.

The second semiconductor layer 30 comprises a layer of mercury-cadmium-telluride having a stoichiometric relationship defined by Hg_{1-y}Cd_{y}Te. The composition value of y may be chosen to be larger than the composition value x of the first semiconductor layer 28, and may typically have a value of 0.3. It is to be understood, however, that other suitable values of y may be chosen and other suitable materials may also be chosen including mercury-cadmium-telluride, mercury-zinc-telluride, mercury-cadmium-selenide, mercury-zinc-selenide, mercury-cadmium-sulfide, mercury-zinc-sulfide, lead-tin-telluride, lead-tin-selenide, lead-tin-sulfide, indium-arsenide-antimonide, gallium-indium-antimonide, or gallium-antimonide-arsenide.

The first semiconductor layer 28 acts as a photodiode base layer while the second semiconductor layer 30 acts as a photodiode collector layer. To increase the collection efficiency of the structure 10, however, the roles of the first and second semiconductor layers 28 and 30 may be reversed (i.e., the second semiconductor layer 30 becoming the base layer and the first semiconductor layer 28 the collector layer). In this case, the composition value of y will be approximately 0.2 and the composition value of x will be approximately 0.3. More generally, however, the second semiconductor layer 30 will become the narrow bandgap material and the first semiconductor layer 28 will become the wide bandgap material. The layers 28 and 30 are doped to have impurities of opposite type, ie., the first semiconductor layer 28 being doped p-type and the second semiconductor layer 30 being doped n-type, or vice-versa. It will be appreciated, however, that isotype heterojunctions may also be employed.

When a photon of light in the infrared spectrum of interest is absorbed by the apparatus structure 10, an electron/hole pair is generated. If the electron/hole pair arrives at the junction between the first and second semiconductor layers 28 and 30 before recombining, the electric field at the junction between the first and second semiconductor layers 28 and 30 will cause the electron to move into the n-type semiconductor layer and the hole to move into the p-type semiconductor layer. This electron/hole migration produces a photocurrent which is proportional to the number of photons received.

To sense the photocurrent generated in the first and second semiconductor layers 28 and 30, the substrate 12 further comprises the heavily doped regions 32 and 34. The heavily doped region 32 allows electrical communication between the readout and signal processing circuits 14 and the first semiconductor layer 28 through the nucleation window 24. The material deposited in the nucleation window 24 can be HgTe or a similar semi-metallic material with crystal structure and lattice constant similar to the semiconductor layer 28 (thus, HgSe, HgS, PbTe, PbSe, PbS, and grey Sn could be alternative choices). This will provide a better ohmic contact between the heavily doped region 32 and the first semiconductor layer 28. The same material is simultaneously deposited in nucleation windows 22 and 26, but there it serves only as a nucleation site for first semiconductor layer 28, not as an ohmic contact. In addition, the heavily doped region 34 allows electrical communication between the readout and the signal processing circuits 14 and the second semiconductor layer 30 through a metallization layer 36 and the ohmic contact 20. The ohmic contact 20 and 36 can be two different metals, the ohmic contact 20 chosen to make good ohmic contact with the heavily doped region 34, and the metallization layer 36 chosen to make good ohmic contact with the second semiconductor layer 30, such as platinum for n-type and gold for p-type. The metallization layer 36 must also be chosen to be a material on which nucleation of first semiconductor layer 28 is suppressed.

When the second semiconductor layer 30 acts as the base of the photodiode, the free charge carriers in the interior of the second semiconductor layer 30 drift toward the interface with second semiconductor layer 28 and recombine. The result of this recombination is to reduce the efficiency with which free charge carriers are collected by the first passivation layer 16. To reduce the recombination velocity of the free charge carriers in the second semiconductor layer 30 when the second semiconductor layer 30 acts as the base of the photodiode, a third semiconductor layer 38 is provided. The third semiconductor layer 38 may be fabricated from mercury-cadmium-telluride having a stoichiometric relationship defined by Hg_{1-z}Cd_{z}Te, in which the composition value of z is chosen to be greater than y. It is to be understood, however, that other suitable materials may be used such as mercury-cadmium-telluride, mercury-zinc-telluride, mercury-cadmium-selenide, mercury-zinc-selenide, mercury-cadmium-sulfide, mercury-zinc-sulfide, lead-tin-telluride, lead-tin-selenide, lead-tin-sulfide, indium-arsenide-antimonide, gallium-indium-antimonide, or gallium-antimonide-arsenide.

The structure 10 further includes an anti-reflection coating 40. The anti-reflection coating 40 is located on the third semiconductor layer 38 and is used to reduce the reflection of incident infrared radiation. The anti-reflection coating 40 is manufactured from a material which has an index of refraction between that of air and the third semiconductor layer 38. While the anti-reflection coating 40 may be fabricated from zinc sulfide, zinc selenide, or zinc telluride, other suitable materials may be used. The structure 10 also comprises the field plate regions 42 which are used to control the relative potential of the first and second semiconductor layers 28 and 30 as well as the first passivation layer 16. The field plates 42 are located below the region where the first and second semiconductor layers 28 and 30 intersect the first passivation layer 16. The field plate regions 42 may either be doped regions in the substrate 12 or metal deposited on the surface of the substrate 12.

Control of electrical potential in the region where layers 28, 30 and 18 intersect is essential to device performance. To control the electric potential in this region, the second passivation layer 18 is chosen to provide stable surface potentials, near the flat band potential, in the first and second semiconductor layers 28 and 30 (i.e., the second passivation layer 18 is chosen to passivate the first and second semiconductor layers 28 and 30) and by using the field plate regions 42 to compensate for any deviation from the flat band condition by the use of an applied potential, in the same way as gates are used to optimize photodiode performance in current practice.

The growth of the first and second semiconductor layers 28 and 30 over the second passivation layer 18 provides automatically a self-passivated buried junction. The existence of field plate region 42 permits optimization of surface potential in the junction region by gate-voltage control.

By providing a structure as described above, the performance of the structure 10 may be optimized both from the signal processing viewpoint as well as from that of infrared detection. The substrate 12 may be silicon, gallium arsenide, or germanium from which signal processing circuits of optimum performance can be fabricated. The first and second semiconductor layers 28 and 30 which are chosen from a material which optimizes infrared detection are then deposited on the substrate by heteroepitaxial selected area deposition. The combination of this detector structure and the substrate 12 thus constitute a monolithic heteroepitaxial focal plane array, and does not suffer from the disadvantages associated with hybridized structures.

The structure 10 may be fabricated in the manner described below. Once the substrate 12 has been formed with the readout and signal processing circuit 14, the heavily doped regions 32 and 34 as well as the field plate regions 42 are formed. The passivation layers 16 and 18 are then deposited on the substrate 12. A contact window is then opened by photolithography in the passivation layers 16 and 18 over the heavily doped region 34. A first layer of metal is applied by vacuum deposition and lift-off so as to form the ohmic contact 20 for the heavily doped region 34. A second photolithographic step is then performed to form the metallization layer 36. The shape of the metallization layer 36 is chosen to form the boundary of the structure 10 and is selected to me ohmic contact with the second semiconductor layer 30.

A third photolithographic step is then used to open the nucleation windows 22-26 in the passivation layers 16 and 18. The shape, size and spacing of the nucleation windows 22-26 are to be determined by the desired detector geometry and characteristics of the epitaxial growth process used. For example, if the lateral growth from the nucleation window occurs at the same rate as the vertical growth, then the windows should be spaced as far apart as they are wide. The number of nucleation windows should also be minimized as an excessive number of nucleation windows may place spacial constraints on the readout and signal processing circuits 14 in the substrate 12. The number and size of the nucleation windows 22-26 can be minimized by maximizing the ratio of the lateral growth rate to the vertical growth rate of the first semiconductor layer 28. In addition, the ratio of the lateral growth rate to the vertical growth rate of the second semiconductor layer 30 should also be maximized so as to provide the largest possible distance between the junction between the first and second semiconductor layers 28 and 30 and the metallization layer 36. By making the first semiconductor layer 28 a thick layer, the number of nucleation windows 22-26 required is reduced. Making the second semiconductor layer 30 thicker allows more tolerance for lateral growth rate variation since the distance between the metallization layer 36 and the junction between the first and second semiconductor layers 28 and 30 become larger.

After opening the nucleation windows 22-26 in the passivation layers 28 and 30, the remaining photoresist is removed from the passivation layer 16 and the substrate 12 is placed in a low-temperature metallorganic vapor phase epitaxial reactor so that in-situ clean-up of the surface of the substrate 12 can be performed. The in-situ surface clean-up may involve ultraviolet ozone etching, atomic hydrogen etching, or etching by other free radicals generated from suitable reactant sources in an ultraviolet or plasma field.

Nucleation crystals are then grown in the nucleation windows 22-26 of the passivation layers 16 and 18. Because the material from which the passivation layer 18 and the metallization layer 36 are formed resist the formation of nucleation crystals, the nucleation crystals only form in the nucleation windows 22-26. Reactant flow into the metallorganic vapor phase epitaxial reactor is then changed to grow the first semiconductor layer 28 which nucleates on the nucleation crystals in the nucleation windows 22-26. The reactant flow is then further changed to grow the second semiconductor layer 30. A final change in the reactant flow permits the growth of the third semiconductor layer 38. Finally, the anti-reflection layer 40 is formed on the third semiconductor layer 38 by vacuum evaporation outside the metallorganic vapor phase reactor.

It will therefore be seen that the present invention is able to provide an apparatus for detecting infrared radiation in which the infrared material can be selected to optimize infrared detection, while the signal-processing material may be selected to optimize the signal processing circuits.

## Claims

1. A monolithic structure for detecting infrared radiation comprising:
a substrate (12) having readout and signal processing circuits (14) integrated therein, said substrate (12) formed from a material selected from the group consisting of silicon, gallium-arsenide, or germanium;
a first semiconductor layer (28) of a first conductivity type grown on said substrate (12) from a material selected from the group consisting of mercury-cadmium-telluride, mercury-zinc-telluride, mercury-cadmium-selenide, mercury-zinc-selenide, mercury-cadmium-sulfide, mercury-zinc-sulfide, lead-tin-telluride, lead-tin-selenide, lead-tin-sulfide, indium-arsenide-antimonide, gallium-indium-antimonide, or gallium-antemonide-arsenide;
a first passivation layer (16) disposed between said substrate (12) and said first semiconductor layer (28);
a plurality of nucleation windows (22, 24, 26) disposed in said first passivation layer (16) operable to control the formation of said first semiconductor layer (28), at least one of said nucleation windows permitting electrical communication between said first semiconductor layer (28) and said readout and signal processing circuits (14);
a plurality of nucleation crystals formed in said nucleation windows (22, 24, 26), said nucleation crystals formed from a material selected from the group consisting of mercury-telluride, mercury-selenide, mercury-sulfide, lead-telluride, lead-selenide, lead-sulfide, or grey tin; and
a second semiconductor layer (30) of a second conductivity type grown on said first semiconductor layer (28) said first and second semiconductor layers operable to deliver an electrical signal to said readout and signal processing circuits (14) in said substrate (12) in response to the infrared radiation received by said first (28) and second (30) semiconductor layers.

2. The apparatus of claim 1, further comprising a second passivation layer (18) disposed between said first passivation layer (16) and said first semiconductor layer (28).

3. The apparatus of claim 2, wherein said second semiconductor layer (30) extends over said first semiconductor layer (28) to contact said second passivation layer (18), said second passivation layer (18) being selected to provide passivation for said first and second semiconductor layers (28, 30).

4. The apparatus of at least one of the claims 1 through 3, wherein nucleation of said first semiconductor layer (28) occurs only in said nucleation windows (22, 24, 26).

5. The apparatus of at least one of the claims 1 through 4, further comprising a third semiconductor layer (38) disposed on said second semiconductor layer (30), said third semiconductor layer (38) operable to reduce the surface recombination velocity of the free charge carriers in said second semiconductor layer (30).

6. The apparatus of claim 5, further comprising a layer (40) of anti-reflection material disposed on said third semiconductor layer (38), said anti-reflection material having an index of refraction between that of air and the third semiconductor layer (38).

7. The apparatus of at least one of the claims 1 through 6, wherein said first, second and third semiconductor layers (28, 30, 38) are grown by metallorganic vapor phase epitaxy.

8. A method for detecting infrared radiation comprising:
forming first (28) and second (30) layers of semiconductor material by growing nucleation crystals in nucleation windows (22, 24, 26) of a first passivation layer (16) which is disposed on a substrate (12), said nucleation crystals being formed from a material selected from the group consisting of mercury-telluride, mercury-selenide, mercury-sulfide, lead-telluride, lead-selenide, lead-sulfide, or grey tin;
exposing said first layer (28) and said second (30) layer of semiconductor material to a source of infrared radiation, said first and second semiconductor layers being formed from a material selected from the group consisting of mercury-cadmium-telluride, mercury-zinc-telluride, mercury-cadmium-selenide, mercury-zinc-selenide, mercury-cadmium-sulfide, mercury-zinc-sulfide, lead-tin-telluride, lead-tin-selenide, and lead-tin-sulfide;
generating a photocurrent in said first (28) and second (30) layers of semiconductor material;
sensing said photocurrent by readout and signal processing circuits (14) disposed within said substrate (14) upon which said first and second semiconductor layers (28, 30) are grown, said substrate (12) being formed of a material selected from the group consisting of silicon, gallium arsenide, or germanium; and
causing electrical communication between said first semiconductor layer (28, 30) and said readout and signal processing circuits (14) through at least one of said nucleation windows.

9. The method of claim 8, wherein said first layer (28) of semiconductor material, said second layer (30) of semiconductor material and said substrate (12) comprise a monolithic structure.

10. The method of claim 8 or 9, wherein said first passivation layer (16) is separated from said first layer (28) of semiconductor material by a second passivation layer (18).

11. The method of at least one of the claims 8 through 10, comprising the additional step of reducing the surface recombination velocity of free charge carriers in said second layer (30) of semiconductor material by disposing a third layer (38) of semiconductor material on said second layer (30) of semiconductor material.

12. The method of claim 11, further comprising the additional step of allowing infrared radiation to pass through a layer (40) of anti-reflection material having an index of refraction between that of air and the third semiconductor layer (38).

13. The method of at least one of the claims 8 through 12, wherein said first, second and third semiconductor layers (28, 30, 38) are formed by metallorganic vapor phase epitaxy.

14. The method of at least one of the claims 8 through 13, wherein said nucleation crystals are formed in said nucleation windows (22, 24, 26) by metallorganic vapor phase epitaxy.

15. An array of monolithic structures (10) for detecting infrared radiation, each of said monolithic structures (10) comprising the apparatus of at least one of the claims 1 through 7.

16. The array of claim 15, wherein a plurality of passivation layers (16, 18) are disposed between said substrate (12) and said first layer (28) of semiconductor material of each monolithic structure (10).

17. The array of claim 15 or 16 wherein each monolithic structure (10) further comprises an ohmic contact (20) permitting electrical communication between said first and second semiconductor layers (28, 30) and said readout and signal processing circuits (14).

## Patentansprüche

1. Monolithische Struktur zum Detektieren infraroter Strahlung mit:
einem Substrat (12) mit darin integrierten Auslese- und Signalverarbeitungsschaltkreisen (14), wobei das Substrat aus einem Material gebildet ist, das aus der Gruppe bestehend aus Silizium, Galliumarsenid oder Germanium ausgewählt ist;
einer ersten Halbleiterschicht (28) von einem ersten Leitfähigkeitstyp, die auf dem Substrat (12) aus einem Material aufgewachsenen ist, das aus der Gruppe bestehend aus Quecksilber-Cadmium-Tellurid, Quecksilber-Zink-Tellurid, Quecksilber-Cadmium-Selenid, Quecksilber-Zink-Selenid, Quecksilber-Cadmium-Sulfid, Quecksilber-Zink-Sulfid, Blei-Zinn-Tellurid, Blei-Zinn- Selenid, Blei-Zinn-Sulfid, Indium-Arsenid-Antimonid, Gallium-Indium-Antimonid und Gallium-Antimonid-Arsenid ausgewählt ist;
einer ersten Passivierungsschicht (16), die zwischen dem Substrat (12) und der ersten Halbleiterschicht (28) angeordnet ist;
einer Mehrzahl von Kristallisationskeimbildungsfenstern (22, 24, 26), die in der ersten Passivierungsschicht (16) angeordnet sind und die Bildung der ersten Halbleiterschicht (28) steuern, wobei wenigstens eines der Kristallisationskeimbildungsfenster die elektrische Kommunikation zwischen der ersten Halbleiterschicht (28) und den Auslese- und Signalverarbeitungsschaltkreisen (14) erlaubt;
einer Mehrzahl von in den Kristallisationskeimbildungsfenstern (22, 24, 26) geformten Keimkristallen, wobei die Keimkristalle aus einem Material gebildet sind, das aus der Gruppe bestehend aus Quecksilbertellurid, Quecksilberselenid, Quecksilbersulfid, Bleitellurid, Bleiselenid, Bleisulfid und Grauzinn ausgewählt ist; und
einer zweiten auf der ersten Halbleiterschicht (28) aufgewachsenen zweiten Halbleiterschicht (30) von einem zweiten Leitfähigkeitstyp, wobei die erste und die zweite Halbleiterschicht ausgelegt sind, den Auslese- und Signalverarbeitungsschaltkreisen (14) elektrische Signale als Antwort von durch die erste (28) und zweite (30) Halbleiterschicht empfangene Infrarotstrahlung zuzuführen.

2. Vorrichtung nach Anspruch 1, weiter umfassend eine zweite Passivierungsschicht (18), die zwischen der ersten Passivierungsschicht (16) und und der ersten Halbleiterschicht (28) angeordnet ist.

3. Vorrichtung nach Anspruch 2, worin die zweite Halbleiterschicht (30) sich über die erste Halbleiterschicht (28) erstreckt, um die zweite Passivierungsschicht (18) zu kontaktieren, wobei die zweite Passivierungsschicht (18) ausgewählt ist, um für die erste und die zweite Halbleiterschicht (28, 30) Passivierung bereitzustellen.

4. Vorrichtung nach wenigstens einem der Ansprüche 1 bis 3, worin die Kristallisationskeimbildung der ersten Halbleiterschicht (28) nur in den Kristallisationskeimbildungsfenstern (22, 24, 26) geschieht.

5. Vorrichtung nach wenigstens einem der Ansprüche 1 bis 4, desweiteren eine dritte auf der zweiten Halbleiterschicht (30) angeordnete Halbleiterschicht (38) umfassend, wobei die dritte Halbleiterschicht (38) eine Verringerung der Obeflächenrekombinationsgeschwindigkeit der freien Ladungsträger in der zweiten Halbleiterschicht (30) bewirkt.

6. Vorrichtung nach Anspruch 5, dewseiteren umfassend eine auf der dritten Halbleiterschicht (38) aufgebrachte Schicht (40) aus einem Anti-Reflexionsmaterial, wobei das Anti-Reflexionsmaterial einen Brechungsindex aufweist, der zwischen dem von Luft und dem der dritten Halbleiterschicht (38) liegt.

7. Vorrichtung nach wenigstens einem der Ansprüche 1 bis 6, worin die erste, zweite und dritte Halbleiterschicht (28, 30, 38) mittels metallorganischer Gasphasenepitaxie aufgewachsen sind.

8. Verfahren zum Detektieren von Infrarotstrahlung mit:
Ausbilden von einer ersten (28) und einer zweiten (30) Schicht aus Halbleitermaterial durch Züchten von Keimkristallen in Kristallisationskeimbildungsfenstern (22, 24, 26) einer ersten Passivierungsschicht (16), die auf einem Substrat (12) angeordnet ist, wobei die Keimkristalle aus einem Material gebildet sind, das aus der Gruppe bestehend aus Quecksilbertellurid, Quecksilberselenid, Quecksilbersulfid, Bleitellurid, Bleiselenid, Bleisulfid oder Grauzinn ausgewählt sind;
die erste Schicht (28) und die zweite Schicht (30) einer Infrarotstrahlungsquelle aussetzen, wobei die erste und die zweite Halbleiterschicht aus einem Material geformt sind, das aus der Gruppe bestehend aus Quecksilber-Cadmium-Tellurid, Quecksilber-Zink-Tellurid, Quecksilber-Cadmium-Selenid, Quecksilber-Zink-Selenid, Quecksilber-Cadmium-Sulfid, Quecksilber-Zink-Sulfid, Blei-Zinn-Tellurid, Blei-Zinn-Selenid, Blei-Zinn-Sulfid ausgewählt ist;
Erzeugen eines Photostroms in der ersten (28) und zweiten (30) Schicht aus Halbleitermaterial;
Erfassen des Photostroms mittels in dem Substrat (12), auf dem die erste und die zweite Halbleiterschicht (28, 30) aufgewachsen sind, angeordneten Auslese- und Signalverarbeitungsschaltkreisen (14), wobei das Substrat (12) aus einem Material aus der Gruppe bestehend aus Silizium, Galliumarsenid und Germanium ausgewählt ist; und
Bewirken von elektrischer Kommunikation zwischen der ersten Halbleiterschicht (28, 30) und den Auslese- und Signalverarbeitungsschaltkreisen (14) über wenigstens eines der Kristallisationskeimbildungsfenster.

9. Verfahren nach Anspruch 8, worin die erste Schicht (28) aus Halbleitermaterial, die zweite Schicht (30) aus Halbleitermaterial und das Substrate (12) eine monolithische Struktur umfassen.

10. Verfahren nach Anspruch 8 oder 9, worin die erste Passivierungsschicht (16) von der zweiten Schicht (30) aus Halbleitermaterial durch eine zweite Passivierungsschicht (18) getrennt ist.

11. Verfahren nach wenigstens einem der Ansprüche 8 bis 10, mit dem zusätzlichen Schritt die Oberflächenrekombinationsgeschwindigkeit von freien Ladungsträgern durch Aufbringen einer dritten Schicht (38) aus Halbleitermaterial auf der zweiten Schicht (30) aus Halbleitermaterial zu verringern.

12. Verfahren nach Anspruch 11, desweiteren mit dem zusätzlichen Schritt zu erlauben, daß Infrarotstrahlung eine Schicht (40) aus Anti-Reflexionsmaterial, das einen Brechungsindex aufweist, der zwischen dem von Luft und dem der dritten Halbleiterschicht (38) liegt, durchdringt.

13. Verfahren nach wenigstens einem der Ansprüche 8 bis 12, worin die erste, zweite und dritte Halbleiterschicht (28, 30, 38) mittels metallorganischer Gasphasenepitaxie gebildet werden.

14. Verfahren nach wenigstens einem der Ansprüche 8 bis 13, worin die Keimkristalle in den Kristallisationskeimbildungsfenstern (22, 24, 26) mittels metallorganischer Gasphasenepitaxie gebildet werden.

15. Feldanordnung aus monolithischen Strukturen (10) zum Detektieren von Infrarotstrahlung, wobei jeder der monolithischen Strukturen (10) eine Vorrichtung nach wenigstens einem der Ansprüche 1 bis 7 enthält.

16. Feldanordnung nach Anspruch 15, worin eine Mehrzahl von Passivierungsschichten (16, 18) zwischen dem Substrat (12) und der ersten Schicht (28) aus Halbleitermaterial jeder der monolithischen Strukturen (10) angeordnet sind.

17. Feldanordnung nach Anspruch 15 oder 16, worin jede monolithische Struktur (10) weiter einen ohmschen Kontakt (20) aufweist, der die elektrische Kommunikation zwischen der ersten und zweiten Halbleiterschicht (28, 30) und den Auslese- und Signalverarbeitungsschaltkreisen (14) erlaubt.

## Revendications

1. Structure monolithique pour la détection d'un rayonnement infrarouge, comportant :
un substrat (12) dans lequel sont intégrés des circuits d'extraction et de traitement de signaux, ledit substrat (12) étant formé d'une matière choisie dans le groupe constitué du silicium, de l'arséniure de gallium ou du germanium ;
une première couche semiconductrice (28) d'un premier type de conductivité formée par croissance sur ledit substrat (12) en une matière choisie dans le groupe constitué des tellurure de mercure et de cadmium, tellurure de mercure et de zinc, séléniure de mercure et de cadmium, séléniure de mercure et de zinc, sulfure de mercure et de cadmium, sulfure de mercure et de zinc, tellurure de plomb et d'étain, séléniure de plomb et d'étain, sulfure de plomb et d'étain, arséniure-antimoniure d'indium, antimoniure de gallium et d'indium ou antimoniure-arséniure de gallium ;
une première couche (16) de passivation disposée entre ledit substrat (12) et ladite première couche semiconductrice (28) ;
plusieurs fenêtres (22, 24, 26) de nucléation disposées dans ladite première couche de passivation (16) et sur lesquelles on peut agir pour commander la formation de ladite première couche semiconductrice (28), au moins l'une desdites fenêtres de nucléation permettant une communication électrique entre ladite première couche semiconductrice (28) et lesdits circuits (14) d'extraction et de traitement de signaux ;
plusieurs cristaux de nucléation formés dans lesdites fenêtres (22, 24, 26) de nucléation, lesdits cristaux de nucléation étant formés d'une matière choisie dans le groupe constitué du tellurure de mercure, du séléniure de mercure, du sulfure de mercure, du tellurure de plomb, du séléniure de plomb, du sulfure de plomb ou de l'étain gris ; et
une seconde couche semiconductrice (30) d'un second type de conductivité formée par croissance sur ladite première couche semiconductrice (28), lesdites première et seconde couches semiconductrices pouvant être activées de façon à délivrer un signal électrique auxdits circuits (14) d'extraction et de traitement de signaux dans ledit substrat (12) en réponse au rayonnement infrarouge reçu par lesdites première (28) et seconde (30) couches semiconductrices.

2. Dispositif selon la revendication 1, comportant en outre une seconde couche (18) de passivation disposée entre ladite première couche (16) de passivation et ladite première couche semiconductrice (28).

3. Dispositif selon la revendication 2, dans lequel ladite seconde couche semiconductrice (30) s'étend au-dessus de ladite première couche semiconductrice (28) pour être en contact avec ladite seconde couche (18) de passivation, ladite seconde couche (18) de passivation étant choisie pour produire une passivation pour lesdites première et seconde couches semiconductrices (28, 30).

4. Dispositif selon au moins l'une des revendications 1 à 3, dans lequel une nucléation de ladite première couche semiconductrice (28) apparaît seulement dans lesdites fenêtres (22, 24, 26) de nucléation.

5. Dispositif selon au moins l'une des revendications 1 à 4, comportant en outre une troisième couche semiconductrice (38) disposée sur ladite deuxième couche semiconductrice (30), ladite troisième couche semiconductrice (38) pouvant être activée de façon à réduire la vitesse de recombinaison en surface des porteurs de charges libres dans ladite deuxième couche semiconductrice (30).

6. Dispositif selon la revendication 5, comportant en outre une couche (40) d'une matière anti-réflexion disposée sur ladite troisième couche semiconductrice (38), ladite matière anti-réflexion ayant un indice de réfraction compris entre celui de l'air et celui de la troisième couche semiconductrice (38).

7. Dispositif selon au moins l'une des revendications 1 à 6, dans lequel lesdites première, deuxième et troisième couches semiconductrices (28, 30, 38) sont formées par croissance par épitaxie métallo-organique en phase vapeur.

8. Procédé pour la détection d'un rayonnement infrarouge, consistant :
à former des première (28) et deuxième (30) couches de matière semiconductrice par croissance de cristaux de nucléation dans des fenêtres (22, 24, 26) de nucléation d'une première couche (16) de passivation qui est disposée sur un substrat (12), lesdits cristaux de nucléation étant formés d'une matière choisie dans le groupe constitué du tellurure de mercure, du séléniure de mercure, du sulfure de mercure, du tellurure de plomb, du séléniure de plomb, du sulfure de plomb ou de l'étain gris ;
à exposer ladite première couche (28) et ladite deuxième couche (30) de matière semiconductrice à une source de rayonnement infrarouge, lesdites première et deuxième couches semiconductrices étant formées d'une matière choisie dans le groupe constitué du tellurure de mercure et de cadmium, du tellurure de mercure et de zinc, du séléniure de mercure et de cadmium, du séléniure de mercure et de zinc, du sulfure de mercure et de cadmium, du sulfure de mercure et de zinc, du tellurure de plomb et d'étain, du séléniure de plomb et d'étain et du sulfure de plomb et d'étain ;
à générer un courant photoélectrique dans lesdites première (28) et seconde (30) couches de matière semiconductrice ;
à détecter ledit courant photoélectrique par des circuits (14) d'extraction et de traitement de signaux disposés à l'intérieur dudit substrat (14) sur lequel lesdites première et deuxième couches semiconductrices (28, 30) sont formées par croissance, ledit substrat (12) étant formé d'une matière choisie dans le groupe constitué de silicium, de l'arséniure de gallium ou du germanium ; et
à établir une communication électrique entre ladite première couche semiconductrice (28, 30) et lesdits circuits (14) d'extraction et de traitement de signaux à travers au moins l'une desdites fenêtres de nucléation.

9. Procédé selon la revendication 8, dans lequel ladite première couche (28) de matière semiconductrice, ladite deuxième couche (30) de matière semiconductrice et ledit substrat (12) constituent une structure monolithique.

10. Procédé selon la revendication 8 ou 9, dans lequel ladite première couche (16) de passivation est séparée de ladite première couche (28) de matière semiconductrice par une seconde couche (18) de passivation.

11. Procédé selon au moins l'une des revendications 8 à 10, comprenant l'étape additionnelle qui consiste à réduire la vitesse de recombinaison en surface de porteurs de charges libres dans ladite deuxième couche (30) de matière semiconductrice en disposant une troisième couche (38) de matière semiconductrice sur ladite deuxième couche (30) de matière semiconductrice.

12. Procédé selon la revendication 11, comprenant en outre l'étape additionnelle qui consiste à permettre à un rayonnement infrarouge de passer à travers une couche (40) de matière anti-réflexion ayant un indice de réfraction compris entre celui de l'air et celui de la troisième couche semiconductrice (38).

13. Procédé selon au moins l'une des revendications 8 à 12, dans lequel lesdites première, deuxième et troisième couches semiconductrices (28, 30, 38) sont formées par épitaxie métallo-organique en phase vapeur.

14. Procédé selon au moins l'une des revendications 8 à 13, dans lequel lesdits cristaux de nucléation sont formés dans lesdites fenêtres (22, 24, 26) de nucléation par épitaxie métallo-organique en phase vapeur.

15. Réseau de structures monolithiques (10) pour la détection d'un rayonnement infrarouge, chacune desdites structures monolithiques (10) comprenant le dispositif d'au moins l'une des revendications 1 à 7.

16. Réseau selon la revendication 15, dans lequel plusieurs couches (16, 18) de passivation sont disposées entre le substrat (12) et ladite première couche (28) de matière semiconductrice de chaque structure monolithique (10).

17. Réseau selon la revendication 15 ou 16, dans lequel chaque structure monolithique (10) comporte en outre un contact ohmique (20) permettant une communication électrique entre lesdites première et deuxième couches semiconductrices (28, 30) et lesdits circuits (14) d'extraction et de traitement de signaux.
